Europäisches Patentamt

European Patent Office

Office européen des brevets

(11) Publication number: **0 606 821 A1**

# (12) EUROPEAN PATENT APPLICATION

(21) Application number: **93810011.2**

(22) Date of filing: **11.01.93**

(51) Int. Cl.5: **H01S 3/19**

(43) Date of publication of application:
**20.07.94 Bulletin 94/29**

(84) Designated Contracting States:
**DE FR GB IT**

(71) Applicant: **INTERNATIONAL BUSINESS MACHINES CORPORATION**

**Armonk, NY 10504(US)**

(72) Inventor: **Buchan, Nicholas I., Dr.**
**55, Oil Mill Road 4**
**Danbury, CT 06810(US)**
Inventor: **Heuberger, Willi**
**Reidholzstrasse 26a**
**CH-8805 Richterswil(CH)**
Inventor: **Roentgen, Peter, Dr.**
**Sonnenbergstrasse 40**
**CH-8800 Thalwil(CH)**

(74) Representative: **Barth, Carl Otto et al**
**IBM Corporation**
**Säumerstrasse 4**
**CH-8803 Rüschlikon (CH)**

(54) **Modulated strain heterostructure light emitting devices.**

(57) Heterostructure laser diodes with active region comprising a quaternary semiconductor compound, the composition of the semiconductor compound of said active region being modulated. This modulation results in an active region having a modulated strain profile ($\Delta a/a$), e.g. a triangular sawtooth-like strain profile, perpendicular to the laser diodes' epitaxial layers, i.e. parallel to a z-axis. The main idea of the present invention is to further increase the strain and to avoid formation of misfit dislocations by compensation, i.e. by inserting strained layers with opposite strain.

FIG. 6

EP 0 606 821 A1

TECHNICAL FIELD

The invention concerns semiconductor light emitting devices such as light emitting diodes and laser diodes, in particular heterostructure diodes, having an active region with modulated strain profile.

BACKGROUND OF THE INVENTION

Most of the semiconductor laser diodes available nowadays are double-heterostructure laser diodes. The manufacturing of these heterostructure diodes, when comparing them with the much more complex quantum-well laser diodes, is rather simple and thus well understood and guarantees high yields.

The present invention concerns improved heterostructure diodes, only requiring slight modifications of already existing manufacturing facilities, rather than starting to built up new manufacturing processes for quantum-well laser diodes and accepting risks of unknown reliability. Prior to switching from conventional double-heterostructure laser diodes to quantum well laser diodes therefore an intermediate step towards improved heterostructure diodes is deemed to be adequate for most of the manufacturers.

When hereinafter referring to heterostructure diodes, Single-Heterostructure diodes (SH) as well as Double-Heterostructure diodes (DH) are addressed, independent of their material, structure, and layer configuration. Some details on Single-Heterostructure and Double-Heterostructure laser diodes and light emitting diodes are given in Chapter 12, 'LED and Semiconductor Lasers' in the book "Physics of Semiconductor Devices", S.M. Sze, Second Edition, John Wiley & Sons, New York, 1981.

It is an object of the present invention to provide for an improved heterostructure semiconductor laser diode or light emitting diode.

It is another object of the present invention to provide for a heterostructure laser diode with reduced threshold current.

It is a further object of the present invention to provide for a heterostructure laser diode with increased differential gain.

It is another object of the present invention to provide for improved heterostructure laser diodes or light emitting diodes with minimum modifications, such that the manufacturing can be carried out using already existing manufacturing processes.

SUMMARY OF THE INVENTION

This has been accomplished by providing for heterostructure laser diodes or light emitting diodes having an active region comprising alternatively compressively strained and tensile strained sublayers of quaternary semiconductor compounds, stacked on each other, resulting in an active region with modulated strain profile perpendicular to the laser diode's epitaxial layers. The net layer strain of this active region can either be zero or shifted towards compressive or tensile strain, e.g. providing for a laser diode with modulated strain profile but adjustable net layer strain. The main idea of the present invention is to increase the strain and to avoid formation of misfit dislocations by compensation, i.e. by inserting strained layers with opposite strain.

DESCRIPTION OF THE DRAWINGS

The invention is described in detail below with reference to the following drawings, which are schematic and not drawn to scale, while more particularly the dimensions of some parts are exaggerated for the sake of clarity.

FIG. 1     shows a simplified cross-section of a conventional broad area heterostructure semiconductor laser diode (Prior Art).

FIG. 2     shows a bandgap ($E_g$) diagram of a conventional Double-Heterostructure (DH) laser diode (Prior Art).

FIG. 3     shows the threshold current density ($J_{th}$) per Quantum Well (QW) versus strain ($\Delta a/a$) in Single Quantum Well (SQW) laser diodes as given in "Low-Pressure MOVPE Growth and Characterization of Strained-Layer InGaAs-InGaAsP Quantum Well Lasers", P.J.A. Thijs et al., Microelectronic Engineering, Elsevier, Vol. 18, 1992, pp. 57 - 74.

FIG. 4     shows the threshold current density ($J_{th}$) versus active layer strain ($\Delta a/a$) for broad area 1,3 $\mu$m wavelength InGaAsP-InP DH lasers with uniform strain (circles) of the present work.

FIG. 5     shows a simplified cross-section of an InGaAsP-InP stripe-geometry Double-Heterostructure semiconductor laser diode, in accordance with a first embodiment of the present invention.

**FIG. 6** shows the bandgap ($E_g$) profile of the InGaAsP-InP DH laser diode of Figure 5, and a triangular sawtooth-like strain ($\Delta a/a$) profile resulting from compositional variation in the laser's active region, in accordance with a first embodiment of the present invention.

**FIG. 7** shows the bandgap ($E_g$) profile and lattice constant (a) of the $In_{1-x}Ga_xAs_yP_{1-y}$ solid solution.

**FIG. 8** shows a simplified cross-section of a broad area InGaAsP-InP DH laser diode, in accordance with a second embodiment of the present invention.

**FIG. 9** shows the rectangular sawtooth-like strain ($\Delta a/a$) profile of the InGaAsP-InP DH laser diode of Figure 8, in accordance with a second embodiment of the present invention.

**FIG. 10** shows the sinusoidal strain ($\Delta a/a$) profile of a DH laser diode, the net layer strain being shifted towards compressive strain, in accordance with a third embodiment of the present invention.

## GENERAL DESCRIPTION

Heterostructure diodes are characterized in that a potential barrier is introduced either on one side (Single-Heterostructure) or on both sides (Double-Heterostructure) of the diode's active region. A typical Single-Heterostructure (SH) diode, as for example described in "Physics of Semiconductor Devices", S.M. Sze, Second Edition, John Wiley & Sons, New York, 1981, cf. Figure 27 on page 709, comprises a p-doped GaAs active region embedded between an n-doped GaAs cladding layer and a p-doped AlGaAs cladding layer. This SH is characterized by a homojunction on one side, i.e. the junction between p-doped GaAs active region and the n-doped GaAs cladding layer, and a heterojunction, i.e. the junction between the p-doped GaAs active region and the p-doped AlGaAs cladding, on the other side. This heterojunction provides for the mentioned potential barrier. In addition, a step of the refractive index in the order of a few percent leads to a better confinement of the light on this side of the active region.

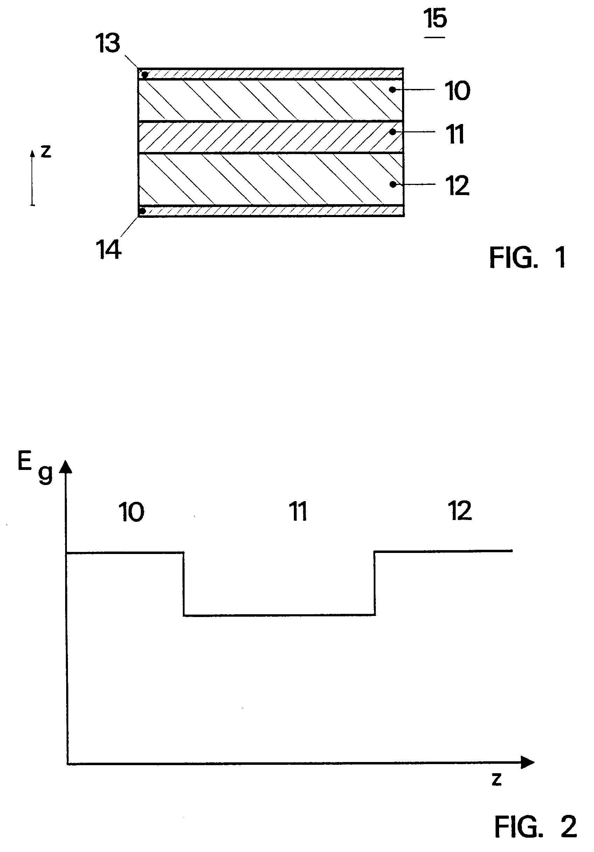

In Double-Heterostructure laser diodes, which were the first diodes to be operated continuously at room temperature and above, the recombination and the optical field are confined to an active region by the introduction of a second potential barrier to the Single-Heterostructure. A cross-sectional view of a conventional broad area Double-Heterostructure laser diode 15 is given in Figure 1. A similar structure is for example set out in Figures 26 and 27, on pages 708 - 709, of the above mentioned book of S.M. Sze. The laser diode 15 consists of an active region 11, e.g. comprising p-doped GaAs, an upper cladding layer 10 and a lower cladding layer 12. The upper cladding layer 10, for example, consists of p-doped AlGaAs, and the lower cladding layer 12 of n-doped AlGaAs. Additionally, the laser 15 has contact metallizations 13 and 14. The bandgap ($E_g$) profile of this laser 15 is illustrated in Figure 2. As can be seen from this Figure, the active region 11 is embedded between two potential barriers provided by the claddings 10 and 12. One disadvantage of such a conventional heterostructure laser diode is its relative high threshold current ($I_{th}$).

The band structure theory has anticipated reduced threshold current densities ($J_{th}$) for quantum-well and heterostructure InP-based lasers containing compressive strained InGaAsP active regions, as for example reported in "Band Structure Engineering for Low Threshold High-Efficiency Semiconductor Lasers", A.R. Adams, Electronics Letters, Vol. 22, No. 5, February 1986, pp. 249 - 250. Originally, only compressive strain was considered for enhancement of the laser performance, as pointed out in the above mentioned theoretical study of A.R. Adams. However, an even more reduced threshold current arises from InP based laser diodes with highly tensile strained InGaAsP active region as for example confirmed by T.C. Chong et al. in their article "Theoretical Gain of Strained-Layer Semiconductor Lasers in the Large Strain Regime", IEEE Journal of Quantum Electronics, Vol. 25, No. 2, February 1989, pp. 171 -178.

Fundamentally, the strain perturbs the valence band structure of the semiconductor, e.g. InGaAsP, so as to decrease the in-plane hole mass and the density of states near the valence band edge. This results in a reduction of carrier loss mechanisms such as Auger recombination and increases the differential gain in the laser. On the other hand, intermediate tensile strain is predicted to instead increase $J_{th}$ due to valence band maxima outside the zone center which encourage additional losses due to indirect transitions as described in "Theoretical Gain in Compressive and Tensile Strained InGaAs/InGaAsP Quantum Wells", S.W. Corzine et al., Applied Physics Letters, Vol. 59, No. 5, July 1991, pp. 588 - 590.

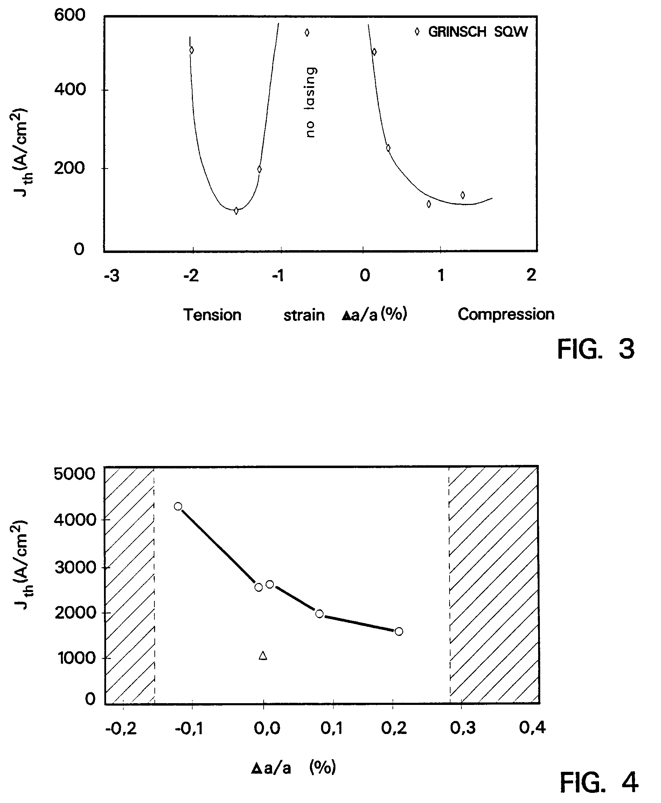

The dependency between strain and threshold current density ($J_{th}$) as reported in "Low-Pressure MOVPE Growth and Characterization of Strained-Layer InGaAs-InGaAsP Quantum Well Lasers", P.J.A. Thijs et al., Microelectronic Engineering, Elsevier, Vol. 18, 1992, pp. 57 - 74, and in "Progress in Quantum Well Lasers: Application of Strain", P.J.A. Thijs, Proc. 13th IEEE Int. Semiconductor Laser Conference, 21 - 25 September 1992, Takamatsu, Kagawa, Japan, paper A-1, pp. 2 - 5, is illustrated in Figure 3. In this Figure, the threshold current densities deduced for infinite cavity length Single-Quantum-Well (SQW) lasers have been plotted versus the strain ($\Delta a/a$) in the well. The variations of the threshold current densities shown in Figure 3 are ascribed to the strain and the quantum size effects on the valence subband structure, as theory predicts the threshold current density to be independent of quantum well width. A dramatically reduced threshold current density for both increasing tensile and compressive strain can be observed. The lowest threshold current density was obtained from a 1,6% tensile strained $In_{0.3}Ga_{0.7}As$ SQW structure which has a lattice constant a = 0,5775 nm. The sharply increased threshold current density for the 2.1% tensile strained SQW structure arises most probably from crystallographic defects. For a QW laser diode with tensile strain of about 0,9% no lasing at room temperature was observed.

Comparable effects have also been reported for InGaAlP visible lasers in "Effect of Strain on the Threshold Current of GalnP/AlGalnP Quantum Well Lasers Emitting at 633nm", by A. Valster et al., Proc. 13th IEEE Int. Semiconductor Laser Conference, 21 - 25 September 1992, Takamatsu, Kagawa, Japan, paper G-1, pp. 152 - 152.

With increasing compressive strain the threshold current density decreases due to the reduction of the in-plane heavy hole effective mass and a reduction of the loss mechanisms as already mentioned. As shown in Figure 3, the threshold current density ($J_{th}$) has been found to decrease monotonically for compressive as well as tensile strain, in the range of 0% $<\Delta a/a <$ 1,5% and -0,9% $<\Delta a/a <$-1,6% , respectively.

In case of compressive strain we have demonstrated similar trends for broad area 1,3 $\mu$m wavelength InGaAsP-InP Double-Heterostructure (DH) lasers. $J_{th}$ of these structures (identified by circles) decreases monotonically with compressive strain, but strongly increases for the moderate tensile strain, as shown in Figure 4. The trends shown in Figures 3 and 4 indicate that even higher compressive and/or tensile strain in the active region should further decrease $J_{th}$. However, a further improvement of $J_{th}$ in these DH structures cannot be achieved with higher strain because misfit dislocations are generated in the structure from exceeding the critical layer thickness. In this particular case for a GalnAsP layer thickness of 120 nm (1200 Å), the maximum strain values are found to be -0,14% $<\Delta a/a < +0,28\%$ , indicated by the hatched regions in Figure 4, as can be estimated from "Defects in Epitaxial Multilayers", J.W. Matthews et al., Journal of Crystal Growth, Vol. 27, 1974, pp. 118-125.

On the other hand, the versatility of most quaternary material systems and of other semiconductor material systems with more than four components, such as AlGaAsP, AlGalnP, InGaAsP, ZnCdSSe, Cu-(AlGa)(SSe), ZnSiP, and AlGalnSb, just to name some thereof, which allow for the independent adjustment of the bandgap and strain, permits different embodiments of the present invention three thereof being hereinafter described. The teaching of the present invention and the hereinafter described embodiments relating to laser diodes can be employed in light emitting diodes, too. Details on the different materials being well suited for the application of the present invention are for example given in:

- "Heterostructure Lasers", H.C. Casey, Jr., and M.B. Panish, Academic Press, Inc. Orlando, 1978, Part B, 'Materials and Operating Characteristics';
- "Material Parameters of $In_{1-x}Ga_xAs_yP_{1-y}$ and Related Binaries", S. Adachi, Journal of Applied Physics, Vol. 53, No. 12, December 1982, pp. 8775 - 8792;
- Landolt-Börnstein, "Numerical Data and Functional Relationships in Science and Technology", Group III: Crystal and Solid State Physics, Vol. 22, Semiconductors, Supplements and Extensions to Volume III/17, Subvolume a, Springer Verlag, Berlin, in particular chapter 2.16.3.

Further details are described in context with the embodiments of the present invention.

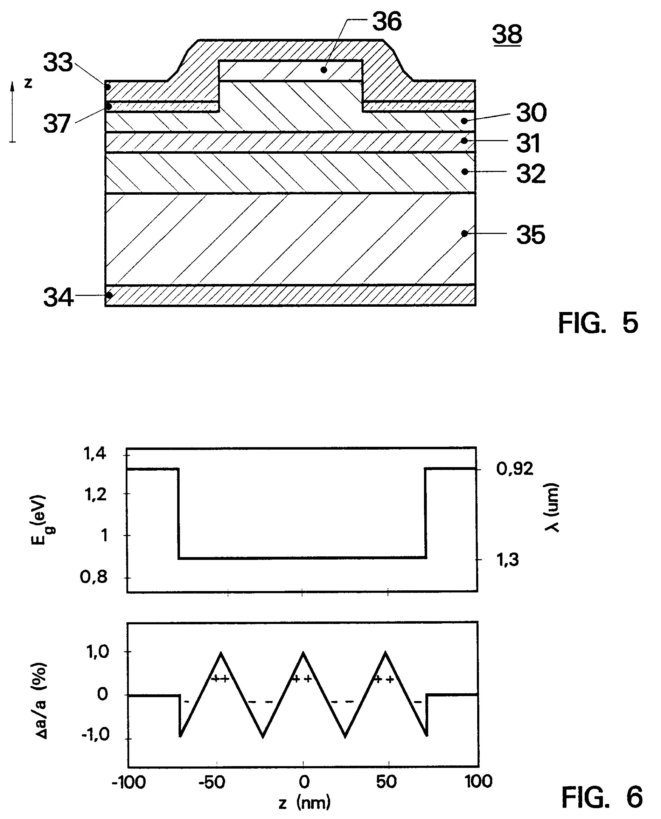

The first embodiment of the present invention is described in connection with Figures 5 and 6. A stripe-geometry InGaAsP laser diode 38 emitting at 1,3 $\mu$m. with double-heterostructure is shown in Figure 5. This laser diode 38 comprises different epitaxial layers subsequently grown on top of an $n^+$-doped InP substrate 35, i.e. an n-doped InP lower cladding layer 32, followed by an undoped InGaAsP active region 31, and a p-doped InP upper cladding layer 30 which has been etched to form a shallow ridge. The ridge itself is covered by a $p^+$-doped InGaAs cap layer 36, the remaining surfaces of the upper cladding layer 30 being covered by an insulation layer 37 consisting of $Si_3N_4$ , for example. Contact metallizations 33 and 34 are situated on both sides of the laser diode 38.

As shown in Figure 6, the bandgap ($E_g$) of the active region 31 is about 0,95 eV ($\equiv \lambda \approx$ 1,3 $\mu$m), the InP cladding layers 30 and 32, with $E_g$ = 1 35eV ($\equiv \lambda \approx$ 918 nm), providing for potential barriers at both sides of the active region 31. According to the invention, the active region 31 comprises strained sublayers, not shown, providing for a modulated strain profile perpendicular to the epitaxial layers of the laser 38, i.e. parallel to the z-axis shown in Figure 5. This modulated strain profile, is illustrated in Figure 6. The lattice constant of the InGaAsP active region 31 is a function of z (a = f(z)). By variation or modulation of the composition of InGaAsP, which is a so-called solid solution, the lattice constant can be modified. The composition of compound semiconductors, such as InGaAsP, is usually indicated by indices x and y. In general, quaternary compounds can be written as $A_{1-x}B_xC_yD_{1-y}$, InGaAsP being known as $In_{1-x}Ga_xAs_yP_{1-y}$.

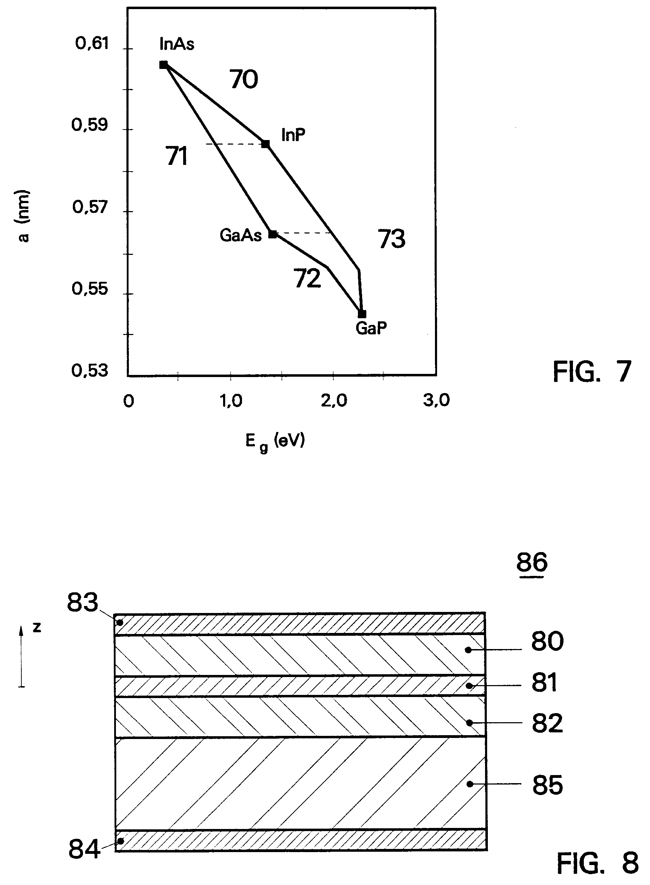

As with other solutions, the properties, in specific the bandgap and lattice constant, of a solid solution depend on the composition of the components. A typical diagram, showing the bandgap ($E_g$) versus lattice constant (a) of $In_{1-x}Ga_xAs_yP_{1-y}$, is given in Figure 7. This simplified diagram has been taken out of the above mention book of H.C. Casey, Jr., and M.B. Panish, cf. Figure 5.1-2 thereof. The border lines 70 - 73 represent the following ternary compounds: $InAs_yP_{1-y}$ (70), $In_{1-x}Ga_xAs$ (71), $GaAs_yP_{1-y}$ (72), $In_{1-x}Ga_xP$ (73). The binary compounds InP, InAs, GaAs and GaP are situated at cross-points of these border lines.

The lattice constant (a) of the active region can be varied without having an influence on the bandgap, as indicated in Figure 6, by subsequently growing InGaAsP sublayers of different composition. The bandgap ($E_g$ in eV) and lattice constant (a in nm) as functions of x and y are defined by equations (1) and (2), respectively.

$$E_g(x,y) = 1,35 + 0,668y + 0,758x^2 + 0,078y^2 - 0,069xy - 0,322x^2y + 0,03xy^2 \qquad (1)$$

and

$$a(x,y) = 0,58688 - 0,04176x + 0,01896y + 0,00125xy \qquad (2)$$

With these equations it is possible to generate a first matrix giving the bandgap ($E_g$ in eV) as function of x and y, and a second matrix showing the dependency between the lattice constant (a in nm) of this quaternary compound and the indices x and y. As can be seen from these matrices as well as from 3-dimensional Figures known in the art, cf. Figure 5.5-5 on page 39 of H.C. Casey, Jr., and M.B. Panish, there are different compositions of InGaAsP having approximately the same bandgap either with tensile or compressive strain.

In the present case, a sawtooth-like strain profile has been realized by variation of the InGaAsP composition of the active region 31. In the first embodiment this modulated strain profile has been created by ramping the composition of the InGaAsP solid solution from $In_{0,5}Ga_{0,5}As_{0,8}P_{0,2}$ , a compound having a lattice constant of about 0,58167 nm, to $In_{0,95}Ga_{0,05}As_{0,4}P_{0,6}$ , a compound having a lattice constant of about 0,5924 nm. These $In_{0,5}Ga_{0,5}As_{0,8}P_{0,2}$ sublayers (lattice constant a = 0,58167 nm) have a lattice mismatch ($\Delta$ a/a) of -0,9% when being grown on a binary InP substrate (a = 0,587 nm) resulting in tensile strain. The $In_{0,95}Ga_{0,05}As_{0,4}P_{0,6}$ sublayers are compressive strained with a lattice mismatch of +0,9% (lattice constant a = 0,5924 nm). The sawtooth-like strain profile shown in Figure 6, is characterized in that the net layer strain, i.e. the total strain of the active region 31, is ±0%. This can be achieved in that the sublayers with tensile strain compensate the sublayers with compressive strain, as indicated by the '+' and '-' signs in Figure 6. More details of the first embodiment are presented in Table 1.

Table 1

| Exemplary details of the first embodiment | | | | | | |
|---|---|---|---|---|---|---|
| Layer | No. | Material | Doping ($cm^{-3}$) | Width (nm) | Bandgap (eV) | $\Delta$a/a (%) |
| substrate | 35 | InP | $6 \times 10^{18}$ (n) | $10^5$ | 1,35 | n.a. |
| cladding | 32 | InP | $1 \times 10^{18}$ (n) | 1500 | 1,35 | 0 |
| active region | 31 | $In_{1-x}Ga_xAs_yP_{1-y}$ | - | 150 | 0,95 | -0,9 - +0,9 modulated |
| cladding | 30 | InP | $1 \times 10^{18}$ (p) | 1500 | 1,35 | 0 |
| cap layer | 36 | $In_{0,5}Ga_{0,5}As$ | $2 \times 10^{19}$ (p) | 500 | 0,75 | 0 |

A second embodiment of the present invention, a broad area DH laser diode 86 with modulated strain profile, is illustrated in Figure 8. This laser diode 86 comprises a quaternary InGaAsP active region 81 with rectangular sawtooth-like strain profile parallel to the z-axis. This active region 81 is embedded between a lower n-doped InP cladding layer 82 and an upper p-doped InP cladding layer 80. The active region 81 with cladding 80 and 82, is grown on top of an InP substrate 85 being n-doped. Contact metallizations 83 and 84 are situated on both sides of this broad area laser diode 86.

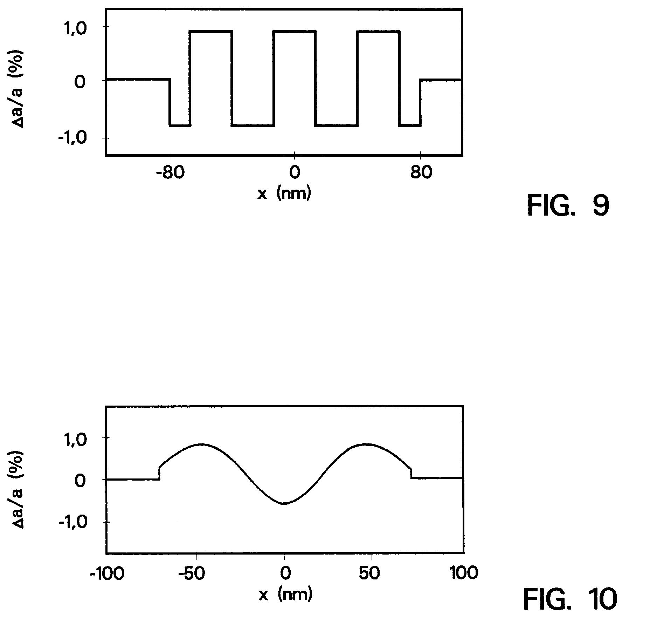

The rectangular sawtooth-like strain profile perpendicular to the laser diode's layers, i.e. parallel to the z-axis, is plotted in Figure 9. As indicated in this Figure, the active region 81 comprises four $In_{0,55}Ga_{0,45}As_{0,75}P_{0,25}$ sublayers with tensile strain ($\Delta$ a/a = - 0,73 %) and three $In_{0,95}Ga_{0,05}As_{0,4}P_{0,6}$

sublayers with compressive strain ($\Delta$ a/a = 0,91 %). Similar to the first embodiment, the bandgap of active region 81 is approximately constant, i.e. $\approx$ 1 eV. The thickness of said sublayers is chosen such that the strain of said compressive strained sublayers compensates the strain of the tensile strained sublayers, providing for an active region 81 with net layer strain $\Delta$ a/a = $\pm$0 %. The second embodiment differs from the first embodiment in that it comprises no sublayers with intermediate tensile strain. Additionally, no ramping from one composition to another is necessary. More details of the second embodiment are set out in Table 2.

Table 2

| Exemplary details of the second embodiment | | | | | | |
|---|---|---|---|---|---|---|
| Layer | No. | Material | Doping ($cm^{-3}$) | Width (nm) | Bandgap (eV) | $\Delta$a/a (%) |
| substrate | 85 | InP | $3 \times 10^{18}$ (p) | $10^5$ | 1,35 | n.a. |
| cladding | 22 | InP | $1 \times 10^{18}$ (p) | 2000 | 1,35 | 0 |
| active region | 81 | $In_{1-x}Ga_xAs_yP_{1-y}$ | - | 160 | 1 | -0,73 - +0,9 modulated |
| cladding | 80 | InP | $1 \times 10^{18}$ (n) | 2000 | 1,35 | 0 |

The modulated strain profile of a third embodiment, e.g. a sinusoidal or cosinusoidal strain profile, is illustrated in Figure 10. This modulated strain profile is characterized in that the net layer strain is shifted towards compressive strain, i.e. $\Delta$ a/a > 0 %.

The above structures have been tested and showed a strongly improved threshold current density ($J_{th}$) in comparison to conventional DH laser diodes being either unstrained, compressively strained, or tensile strained. The reduction in threshold current density is about 25 % and demonstrates an important improvement for the modulated strain profile heterostructure lasers in accordance with the present invention. In addition, strain modulated heterostructure lasers, SH laser as well as DH lasers, are characterized by an increase of 70% in differential gain leading to an about 30% higher modulation speed.

The bandgap has not necessarily to be constant. The InGaAsP and other compound semiconductor systems provide for a degree of freedom allowing to adjust the bandgap almost independently from the lattice constants. Embodiments are conceivable having a modulated strain profile and bandgap. Furthermore, the modulated strain profile does not even have to be a periodic function or an analytical function at all.

To realize to above described embodiments a growth process is to be used which allows to obtain the spatial compositional variations, leading to an appropriate modulated strain profile, in a controlled manner. Suitable processes to be used are MOVPE, MBE, CBE or VPE.

## Claims

1. Heterostructure semiconductor laser (38; 86) diode or light emitting diode with a quaternary semiconductor compound active region (31; 81) embedded between an upper (30; 80) and a lower (32; 82) cladding layer, at least one of said cladding layers (30, 32; 80, 82) providing for a potential barrier, said diode (38; 86) being characterized in that said active region (31; 81) comprises compressively strained and tensile strained sublayers stacked on each other, providing for an active layer (31; 81) with modulated strain profile perpendicular to the laser diodes' layers.

2. The diode (86) of claim 1, wherein said active region (81) comprises at least one compressively strained sublayer and one tensile strained sublayer, the net layer strain of the whole active region (81) being approximately zero.

3. The diode (38; 86) of claim 1 or 2, wherein the strain of the active region (31; 81) is modulated perpendicular to the laser's layers by varying the composition of the quaternary semiconductor compound of said active region (31; 81) when subsequently growing the sublayers of the active region (31; 81), providing for a sawtooth-like, sinusoidal, or cosinusoidal modulated strain profile.

4. The diode of claim 3, wherein said modulated strain profile is an aperiodic function or a non-analytical function.

5. The diode of claim 1 or 2, comprising an n-doped InP cladding layer and a p-doped InP cladding layer embedding said active region comprising undoped or slightly doped $In_{1-x}Ga_xAs_yP_{1-y}$ sublayers.

6. The diode of claim 5, wherein said sublayers consist of $In_{0,55}Ga_{0,45}As_{0,75}P_{0,25}$ being tensile strained, or $In_{0,95}Ga_{0,05}As_{0,4}P_{0,6}$ being compressive strained.

7. The diode of claim 5, wherein the composition of said active region is ramped between $In_{0,5}Ga_{0,5}As_{0,8}P_{0,2}$ being tensile strained and $In_{0,95}Ga_{0,05}As_{0,4}P_{0,6}$ being compressively strained.

FIG. 1

FIG. 2

FIG. 3

FIG. 4

FIG. 5

FIG. 6

FIG. 7

FIG. 8

FIG. 9

FIG. 10

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | ELECTRONICS LETTERS. vol. 27, no. 14, 4 July 1991, STEVENAGE, HERTS, GB pages 1268 - 1270 C.P SELTZER ET AL 'Zero net strain mqw lasers' | 1,2 | H01S3/19 |
| A | * the whole document * | 5-7 | |
| X | APPLIED PHYSICS LETTERS. vol. 58, no. 18, May 1991, NEW YORK US pages 1952 - 1954 B.I. MILLER ET AL 'Strain compensated strained layer superlattices for 1,5 mum wavelength lasers' * the whole document * | 1,2 | |
| A | APPLIED PHYSICS LETTERS. vol. 58, no. 20, 20 May 1991, NEW YORK US pages 2220 - 2222 M. JOMA ET AL 'High power 1.48 mum mqw laers with strained quaternary wells enterily grown by MOVPE' * the whole document * | 1 | TECHNICAL FIELDS SEARCHED (Int. Cl.5 ) |
| D,A | IEEE JOURNAL OF QUANTUM ELECTRONICS. vol. 25, no. 2, February 1989, NEW YORK US pages 171 - 178 T. C. CHONG ET AL 'Theoretical gain of strained layer semiconductor lasers in the large strain regime' * the whole document * | 1 | H01S H01L |

-/--

The present search report has been drawn up for all claims

| Place of search | Date of completion of the search | Examiner |
|---|---|---|
| THE HAGUE | 03 SEPTEMBER 1993 | CLAESSEN L.M. |

European Patent
Office

**EUROPEAN SEARCH REPORT**

Application Number

EP    93 81 0011
Page 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | JOURNAL OF APPLIED PHYSICS. vol. 58, no. 1, July 1985, NEW YORK US pages 37 - 39 H. KAWANISHI ET AL 'Low threshold current density of GaInAsP visible injection laser diodes lattice matched with (100) GaAs emitting at 705 nm' * the whole document * | 1 | |
| A | PATENT ABSTRACTS OF JAPAN vol. 17, no. 203 (E-1354)21 April 1993 & JP-A-04 346 485 ( SUMITOMO ) 2 December 1992 * abstract * | 1 | |

TECHNICAL FIELDS
SEARCHED (Int. Cl.5 )

The present search report has been drawn up for all claims

| Place of search | Date of completion of the search | Examiner |
|---|---|---|
| THE HAGUE | 03 SEPTEMBER 1993 | CLAESSEN L.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)